# EUROPEAN PATENT APPLICATION

(11) **EP 4 685 305 A1**
(43) Date of publication of application: **28.01.2026**
(21) Application number: 25188677.6
(22) Date of filing: 10.07.2025
(51) Int. Cl.: E04C 3/07, E04C 3/04

(54) **FRAMEWORK MEMBER**

(30) Priority: 23.07.2024 GB 202410746
(71) Applicant: Fortescue Zero Limited, Kidlington, England OX5 1GB (GB)
(72) Inventor: RIDLEY, Ewan, Kidlington, OX5 1GB (GB); MATCHAM, Benn, Kidlington, OX5 1GB (GB)
(74) Representative: HGF

(57) **Abstract**

Disclosed is a framework member (10) comprising, a top-hat portion (12) and a return portion (14), where the top-hat portion (12) comprises an open brim wall (16), an open side wall (18) extending from the open brim wall (16), a crown wall (20) extending from the open side wall (18), a closed side wall (22) extending from the crown wall (20) and a closed brim wall (24) extending from the closed side wall (22). The return portion (14) comprises a return wall (26) extending from the closed brim wall (24). The open brim (16), open side (18), crown (20), closed side (22) and closed brim (24) walls form, in cross-section, a top-hat shape and the closed side (22), closed brim (24) and return wall (26) form, in cross-section, a channel (28).

## Description

### TECHNICAL FIELD

The present disclosure relates to a framework members. Aspects of the invention relate to a framework member and to a framework.

### BACKGROUND

Frameworks formed from framework members are often used in the formation of structures (for instance enclosures for components and/or equipment). Nonetheless, such frameworks can suffer from one or more drawbacks. They can be relatively complicated or difficult to assemble. The frameworks can use more members and/or fixings/connection operations than is desirable in order to provide adequate/desired strength and/or framework form. The frameworks can use more members and/or fixings/connection operations than is desirable in order to provide adequate/desired support and/or attachment opportunities for parts of a broader structure based on the framework (e.g. panelling supported by the framework). Connection points between framework members may be weaker than is desired. The frameworks can be heavier than is desired. The frameworks can be susceptible to miss-assembly.

It is an aim of the present invention to address one or more of the disadvantages associated with the prior art.

### SUMMARY OF THE INVENTION

According to a first aspect of the invention there is provided a framework member comprising, a top-hat portion and a return portion, where
the top-hat portion comprises an open brim wall, an open side wall extending from the open brim wall, a crown wall extending from the open side wall, a closed side wall extending from the crown wall and a closed brim wall extending from the closed side wall, and
the return portion comprises a return wall extending from the closed brim wall, and where
the open brim, open side, crown, closed side and closed brim walls form, in cross-section, a top-hat shape and
the closed side, closed brim and return wall form, in cross-section, a channel.

The framework member may for instance be an extrusion or may have been produced via another process (e.g. stamped or moulded).

The framework member may be considered a framework element arranged for use in combination with further instances of the member and/or other framework elements in forming a framework and/or broader structure.

It may be considered that in order, across (i.e. the lateral/width direction) the member, there is the open brim wall, open side wall, crown wall, closed side wall, closed brim wall and return wall.

It may be that in each instance where one of the walls meets another (i.e. each pair of adjacent walls), that they do so substantially at respective longitudinal edges of those walls.

The top-hat portion may provide enhanced rigidity and/or strength to the member whilst allowing the member to nonetheless be of relatively low profile (i.e. to have limited overall height).

The form of the member also provides multiple faces/surfaces which may be suited to providing support and/or engagement and/or an attachment point (e.g. for one or more further instances of the member, alternative framework elements and/or panelling which might be used to at least partially enclose a structure/framework including the member). Additionally, some of these faces/surfaces (e.g. associated with the crown wall, inner and outer brim walls and/or return wall) may be at least substantially perpendicular or opposite to one another, which may serve to better facilitate the formation of frameworks/structures e.g. the creation of corners and/or junctions. Nonetheless, one, some or all of the walls may not be provided in perpendicular and parallel relationships to the others. For instance, the open side and/or closed side walls of the top-hat portion could be somewhat sloped. Additionally or alternatively, whilst the channel may be substantially U-shaped, an alternative would be to provide the return wall and/or the closed side wall with a shallower slope (for instance of 30degs, 45degs or 60degs) as may be suited to the arrangement of the framework envisaged.

Furthermore, the provision of the return wall allows for the formation of the channel bounded by the closed side, closed brim and return walls. This may provide additional options in terms supporting and/or engaging and/or attaching instances of the member and/or the member with other framework elements. In particular, it may in some situations create and/or facilitate opportunities for self-jigging (i.e. to some extent self-supporting or retaining in at least one direction) of joints of a framework which includes the member. This may assist (for instance) during assembly.

The member may be arranged to be a structural element and/or load bearing element in a framework and/or structure including a framework to which it contributes.

In some embodiments the open brim, crown and closed brim walls are substantially parallel with each other and are substantially perpendicular to the open side, closed side and return walls.

Such a member may be better suited to contribute to the formation of frameworks with right angle corners and/or joints. It may additionally or alternatively be that the open and closed brim walls are aligned (e.g. coplanar).

In some embodiments the open side and closed side walls are of substantially the same height.

This may better facilitate supporting and/or engaging and/or attaching the member and a further instance thereof or another framework element (e.g. in view of a more consistent height across the member). It may additionally or alternatively better facilitate supporting and/or engaging and/or attaching the member and a further instance thereof in particular arrangements whilst maintaining substantially flush/consistent surfaces across an interface between the two instances of the member. This may be beneficial when for instance attaching panelling across the interface.

In some embodiments the return wall is of substantially the same height as the open side and closed side walls.

Again, this may be beneficial in terms of facilitating supporting and/or engaging and/or attaching the member and a further instance thereof or another framework element and/or in producing flush/consistent surfaces in such relationships.

In some embodiments the member has an inner side surface corresponding to an inner side of the top-hat shape and an outer side surface corresponding to an outer side of the top-hat shape and a perpendicular distance between an open brim wall inner side surface of the open brim wall and a crown wall outer side surface of the crown wall is substantially equal to a perpendicular distance between a closed side wall outer side surface of the closed side wall and a return wall inner side surface of the return wall.

As will be appreciated, the open brim wall inner side surface and return wall inner side surface form part of the inner side surface and the crown wall outer side surface and closed side wall outer side surface form part of the outer side surface.

Expressed another way, the height of the top-hat portion is substantially equal to the width of the channel associated with the closed side, closed brim and return wall.

This arrangement may facilitate self-jigging and/or cooperative engagement between an end of one instance of the member and a channel formed by the closed side, closed brim and return walls of another, in forming a substantially right angled T-junction or right angled corner or an oblique angled joint from the two instances of the member. This may be at least in part by insertion of at least part of one end of one instance of the member into the channel (e.g. in a perpendicular or oblique manner) formed by the closed side, closed brim and return walls of another instance of the member. If for example a first instance of the member were considered to have its longitudinal direction with a component in an x or y axis, support and/or engagement and/or attachment between a second instance and the first instance, with the longitudinal direction of the second instance having a component in a corresponding z axis, may be better facilitated. This may facilitate the use of two instances of the member (i.e. the same member form) in combination, to form a more complex framework. For instance, where, in simplified terms, the member is considered to provide a 2D object, the described features may better facilitate the creation of a 3D framework using multiple instances of the member. Additionally or alternatively, the likelihood of mis-assembly may be reduced.

It may be that the perpendicular distance between the open brim wall inner side surface and the crown wall outer side surface is smaller (e.g. fractionally/marginally) than the perpendicular distance between the closed side wall outer side surface and the return wall inner side surface. The difference may be sufficient to better facilitate insertion of at least part of one end of one instance of the member into the channel formed by the closed side, closed brim and return walls of another instance of the member. The fit may nonetheless be a close or tight fit. The difference may for instance be in the order of 1% of the perpendicular distance between the closed side wall outer side surface and the return wall inner side surface.

As will be appreciated, the inner side surface could additionally or alternatively be described as corresponding to an outer side of the channel associated with the closed side, closed brim and return walls. Further, the outer side surface could additionally or alternatively be described as corresponding to an inner side of the channel associated with the closed side, closed brim and return walls.

In some embodiments the member has a full-step end feature at one of its ends where the open brim and closed brim walls are absent from the end of the member leaving a nose portion of the full-step end feature formed by the open side, crown, closed side and return walls.

Consequently, it may be considered that the open brim and closed brim walls have step backs by substantially the full height of the return wall. Each of the open side, crown, closed side and return walls may remain at their original lengths or at least be maintained protruding beyond the open brim and closed brim walls. That is, the open brim and closed brim walls are stepped back with respect to the ends of each of the open side, crown, closed side and return walls e.g. by the length along the member substantially corresponding to the height of the return wall.

The full-step end feature may allow a nose portion formed by the open side, crown, closed side and return walls at the relevant end of the member, to be inserted into a channel formed by the closed side, closed brim and return walls of another instance of the member (i.e. a receiving member). Specifically, insertion of the nose portion may not then be prevented by contact of the open brim and closed brim walls of the member to be inserted with the return wall of the receiving member. As a consequence of the insertion, a substantially right angled T-junction or right angled corner or oblique angled joint may be formed by the two members.

The open brim and closed brim walls may have step backs (absent portions) that are substantially rectangular and/or extend from the end of the member for a length along the member substantially corresponding to the height of the return wall. This may leave a square edge to the open and closed brim walls. Such an arrangement may suit the creation of a right angled T-junction or right angled corner. Alternatively, the relevant end of the member may be obliquely formed or cut (i.e. to give the nose portion an oblique end to suit the angle to be made by the two instances of the member following the insertion) and the absent portions may be shaped such that the remaining open brim and closed brim walls have a similar oblique angled edge (e.g. the absent portion may be parallelogram shaped). Consequently, it may be considered that step backs in the open and closed brim walls are obliquely formed. Regardless, they may be sized and shaped to prevent interference (and optionally closely fit) with the return wall of the receiving member when the nose portion is inserted at a desired oblique angle. This approach may suit the creation of an oblique angle joint between the instances of the member. The creation of an oblique angled joint might for example be desirable where an oblique corner brace is to be formed by one of the instances of the member.

In such an insertion, it may be that an end of the nose portion of the inserted member faces and optionally substantially abuts (e.g. along the full extent of its width) the closed brim wall of the receiving member. Additionally or alternatively, it may be that the crown wall of the inserted member faces the closed side wall of the receiving member. Additionally or alternatively, it may be that the lateral/width direction of the inserted member extends along the longitudinal/length direction of the receiving member.

Such an insertion may provide support and/or engagement and/or attachment options in respect of two instances of the member (particularly as regards creation of right angled T-junctions, right angled corners or oblique angled joints by them).

Through such an insertion, a degree of engagement tending to prevent relative movement in some directions may be achieved. The nose portion may for instance be substantially abutted from three sides (respectively by the closed side, closed brim and return walls of the receiving member). This may offer a degree of self-jigging (e.g. prior to attachment, for instance via welding). Nonetheless, in other directions, the insertion may allow for continued movement, which may be of assistance during assembly (e.g. allowing adjustment/repositioning).

Because the nose portion may be substantially abutted on three sides, there may be the opportunity to create a strongerjoint than might otherwise be possible.

The full-step end feature may also reduce the likelihood of miss-assembly.

In some cases, instances of the full-step end feature may be provided at both ends of the member.

In some embodiments the member has a part-step end feature where the open brim and closed brim walls are absent from the end of the member for a length along the member that is less than the height of the return wall and a nose portion is formed by the open side, crown, closed side and return walls.

Consequently, it may be considered that the open brim and closed brim walls have step backs by a part of the height of the return wall. The open brim and closed brim walls may for instance be absent/removed for a length that is substantially half the height of the return wall.

Each of the open side, crown, closed side and return walls may remain at their original lengths or at least may be maintained protruding beyond the open brim and closed brim walls. That is, the open brim and closed brim walls are stepped back with respect to the ends of each of the open side, crown, closed side and return walls e.g. by the same length along the member that is part of the height of the return wall.

In certain circumstances, this part-step end feature may allow a nose portion formed by the open side, crown, closed side and return walls at the relevant end of the member, to be inserted into a channel formed by the closed side, closed brim and return walls of another instance of the member (i.e. a receiving member).

Specifically, it may be that the part-step end feature is complemented with a cooperating part-step side feature locally reducing the height of the return wall of the receiving member in a desired location for support and/or engagement and/or attachment of the part-step end feature of the member to be inserted. In this case, insertion of the nose portion may not be prevented by contact of the open brim and closed brim walls of the member to be inserted with the return wall of the receiving member. As a consequence of the insertion, a substantially right angled T-junction or right angled corner or an oblique angled joint may be formed by the two members. The nature of the complimentary relationship between the absent lengths of open brim and closed brim walls in the member to be inserted and the reduction in the height of the return wall of the receiving member, may be such that the length of absent material from the open brim wall or closed brim wall in combination with the length of the reduction in the return wall of the receiving member, amounts to substantially the full height of the return wall.

The open brim and closed brim walls may have step backs (absent portions) that are substantially rectangular and/or extend from the end of the member. This may leave a square edge to the open and closed brim walls. Such an arrangement may suit the creation of a right angled T-junction or right angled corner. Where however the it is desired to create an oblique angled joint, an alternative approach may be used. The relevant end of the member may be obliquely formed or cut (i.e. to give the nose portion an oblique end to suit the angle to be made by the two instances of the member following the insertion) and the absent portions may be shaped such that the remaining open brim and closed brim walls have a similar oblique angled edge (e.g. the absent portion may be parallelogram shaped). Consequently, it may be considered that step backs in the open and closed brim walls are obliquely formed. Regardless, they may be sized and shaped to prevent interference (and optionally closely fit) with the return wall of the receiving member, as formed with the cooperating part-step side feature, when the nose portion is inserted at a desired oblique angle. In the oblique angle case, the part-step side feature may also be formed in a manner to compliment the oblique angle of the joint to be created. Thus it may be that side walls of a slot forming the part-step side feature are angled to complement the oblique angle of the joint to be created (and therefore the oblique angle in which the open brim and closed brim walls to be accommodated are/will be presented). The creation of an oblique angle might for example be desirable where an oblique corner brace is to be formed by one of the instances of the member.

In such an insertion, it may be that an end of the nose portion of the inserted member faces and optionally substantially abuts (e.g. along the full extent of its width) the closed brim wall of the receiving member. Additionally or alternatively, it may be that the crown wall of the inserted member faces the closed side wall of the receiving member. Additionally or alternatively, it may be that the lateral/width direction of the inserted member extends along the longitudinal/length direction of the receiving member.

Such an insertion may provide support and/or engagement and/or attachment options in respect of two instances of the member (particularly as regards creation of right angled T-junctions or right angled corners or oblique angled joints by them).

An enhanced degree of engagement by comparison with the full-step end feature arrangement described above may arise. Specifically, in addition to the degree of engagement (movement restriction) provided by the full-step end feature arrangement, relative movement in additional directions may be prevented (e.g. sliding of the nose portion in either direction along the channel). This may be as a consequence of respective abutments between the open brim and closed brim walls of the inserted member with the return wall of the receiving member. This may offer further enhanced self-jigging and/or the potential for a stronger joint.

Similarly to the full-step end feature, the part-step end feature may reduce the likelihood of miss-assembly.

In some cases, instances of the part-step end feature may be provided at both ends of the member. As will be appreciated, depending on constructional need/preference, one end of the member may be provided with the full-step end feature and the other with the part-step end feature.

In some embodiments the member has a part-step closed side feature where the return wall is provided with a slot to reduce its height over a length along the member substantially corresponding to the width of the top-hat portion.

The slot may be rectangular in shape (e.g. where a right angled T-junction or right angled corner is to be formed at the part-step open side feature via a joint with a further instance of the member). Alternatively, the slot may be parallelogram shaped (e.g. having oblique side walls) to complement the angle of an oblique joint where such an oblique joint is to be formed at the part-step open side feature via a joint with a further instance of the member.

Adjacent to the part-step closed side feature, the return wall may remain at its original (nominal) height.

The length along the member substantially corresponding to the width of the top-hat portion over which the slot is provided may correspond to an accommodation for the width/lateral extent of the open brim and closed brim walls.

In some embodiments the part-step closed side feature may comprise a single continuous slot. Alternatively, it may be that two discrete slots are provided (one to accommodate a relevant part of the closed brim wall and one to accommodate a relevant part of the open brim wall of the part-step end feature of an inserted member).

The part-step closed side feature may be considered part of a receiving member and may cooperate (as previously described) with the part-step end feature formed in another instance of the member (an inserted member).

In such an insertion, it may be that an end of the nose portion (square or obliquely formed) of the inserted member faces and optionally abuts (e.g. along the full extent of its width) the closed brim wall of the receiving member. Additionally or alternatively, it may be that the crown wall of the inserted member faces the closed side wall of the receiving member. Additionally or alternatively, it may be that the lateral/width direction of the inserted member extends along the longitudinal/length direction of the receiving member.

The location along the member at which the part-step closed side feature is provided may be selected in accordance with, for instance, the desired/designed position of a right angled T-junction or right angled corner or oblique angled joint using the two instances of the member. The part-step closed side feature may for instance be anywhere intermediate the ends (e.g. for a right angled T-junction or oblique angled joint) or at one or other of the ends (e.g. for a right angled corner or oblique angled joint) of the member.

The member may have multiple such part-step side features where for instance multiple right angled corners and/or right angled T-junctions and/or oblique angled joints are desired along its length. Additionally or alternatively, it may have one or more of the end features previously described or two of the end features that are different to one another.

In some embodiments the member has a part-step open side feature where the open brim wall is provided with a slot to reduce its width over a length along the member substantially corresponding to the width of the top-hat portion.

The slot may be rectangular in shape (e.g. where a right angled T-junction or right angled corner is to be formed at the part-step open side feature via a joint with a further instance of the member). Alternatively, the slot may be parallelogram shaped (e.g. having oblique side walls) to complement the angle of an oblique joint where such an oblique joint is to be formed at the part-step open side feature via a joint with a further instance of the member.

Adjacent to the part-step open side feature, the open brim wall may remain at its original (nominal) width.

The length along the member substantially corresponding to the width of the top-hat portion over which the slot is provided may correspond to an accommodation for the width/lateral extent of the open brim and closed brim walls.

In some embodiments the part-step open side feature may comprise a single continuous slot. Alternatively, it may be that two discrete slots are provided (one to accommodate a relevant part of the closed brim wall and one to accommodate a relevant part of the open brim wall of the part-step end feature of an inserted member).

The part-step open side feature may be considered part of a receiving member and may cooperate with the part-step end feature described above formed in another instance of the member (an inserted member).

In such a cooperation it may be that an end of the nose portion (square or obliquely formed) of the inserted member faces and optionally abuts (e.g. along the full extent of its width) the open side wall of the receiving member. Additionally or alternatively, it may be that the lateral/width direction of the inserted member extends along the longitudinal/length direction of the receiving member.

This may provide another support and/or engagement and/or attachment option utilising two instances of the member. Especially when further used in combination with at least one additional instance of the member having an engagement whereby one of the described nose portions is inserted into the described channel, a framework may be created whereby instances of the member have their longitudinal axes respectively with components in an x axis, a y axis and a z axis. This may be thought of as a 3D framework.

The location along the member at which the part-step open side feature is provided may be selected in accordance with, for instance, the desired/designed position of a right angled T-junction, right angled corner or oblique angled joint using the two instances of the member. The part-step open side feature may for instance be anywhere intermediate the ends (e.g. for a right angled T-junction or oblique angled joint) or at one or other of the ends (e.g. for a right angled corner or oblique angled joint) of the member.

The member may have multiple such part-step open side features and/or a combination of one or more part-step open side features and one or more part-step closed side features. Additionally or alternatively, it may have one or more of the end features previously described or two of the end features that are different to one another.

According to a second aspect of the invention there is provided a framework comprising the framework member discussed above.

In some embodiments the framework member is a first framework member having the full-step end feature and the framework further comprises a second framework member corresponding to any of the framework members discussed above and where a substantially right angled T-junction or right angled corner or oblique angled joint is formed by the engagement of the first and second framework members, such that the nose portion of the full-step end feature of the first framework member is inserted between the closed side and return walls of the second member.

In some embodiments the framework member is a first framework member having the part-step end feature and the framework further comprises a second framework member having the part-step closed side feature and where a substantially right angled T-junction or right angled corner or oblique angled joint is formed by the engagement of the first and second framework members, such that the nose portion of the part-step end feature of the first framework member is inserted between the closed side and return walls of the second member and with respective parts of the open brim and closed brim walls of the first framework member being accommodated within the part-step closed side feature of the second framework member.

In some embodiments the framework member is a first framework member having the part-step end feature and the framework further comprises a second framework member having the part-step open side feature and where a substantially right angled T-junction or right angled corner or oblique angled joint is formed by the engagement of the first and second framework members, such that the end of the first framework member having the part-step end feature is facing an open side wall outer side surface of the open side wall of the second framework member and with respective parts of the open brim and closed brim walls of the first framework member being accommodated within the part-step open side feature of the second framework member.

In some embodiments the framework is a box framework.

In some embodiments the framework is made entirely from multiple instances of the framework member.

This may be possible given the form of the framework which lends itself to interconnection as necessary in order to form frameworks of various different forms (including for instance box shaped frameworks).

Within the scope of this application it is expressly intended that the various aspects, embodiments, examples and alternatives set out in the preceding paragraphs, in the claims and/or in the following description and drawings, and in particular the individual features thereof, may be taken independently or in any combination. That is, all embodiments and/or features of any embodiment can be combined in any way and/or combination, unless such features are incompatible. The applicant reserves the right to change any originally filed claim or file any new claim accordingly, including the right to amend any originally filed claim to depend from and/or incorporate any feature of any other claim although not originally claimed in that manner.

### BRIEF DESCRIPTION OF THE DRAWINGS

One or more embodiments of the invention will now be described, by way of example only, with reference to the accompanying drawings, in which:
**Figure 1** shows a perspective view of a framework member according to an embodiment of the invention;
**Figure 2** shows a perspective view of a framework member according to an embodiment of the invention;
**Figure 3** shows a perspective view of a framework member according to an embodiment of the invention;
**Figure 4** shows a perspective view of two framework members connected according to an embodiment of the invention;
**Figure 5** shows a perspective view of two framework members connected according to an embodiment of the invention;
**Figure 6** shows a perspective view of two framework members connected according to an embodiment of the invention;
**Figure 7** shows a perspective view of a framework member according to an embodiment of the invention;
**Figure 8** shows a perspective view of two framework members connected according to an embodiment of the invention;
**Figure 9** shows a perspective view of three framework members connected according to an embodiment of the invention;
**Figure 10** shows a perspective view of three framework members connected according to an embodiment of the invention;
**Figure 11** shows a perspective view of three framework members connected according to an embodiment of the invention;
**Figure 12** shows a perspective view of a structure comprising a framework member according to an embodiment of the invention;
**Figure 13** shows a perspective view of a box structure comprising a framework according to an embodiment of the invention; and
**Figure 14** shows a perspective view of a structure comprising a framework member according to an embodiment of the invention.

### DETAILED DESCRIPTION

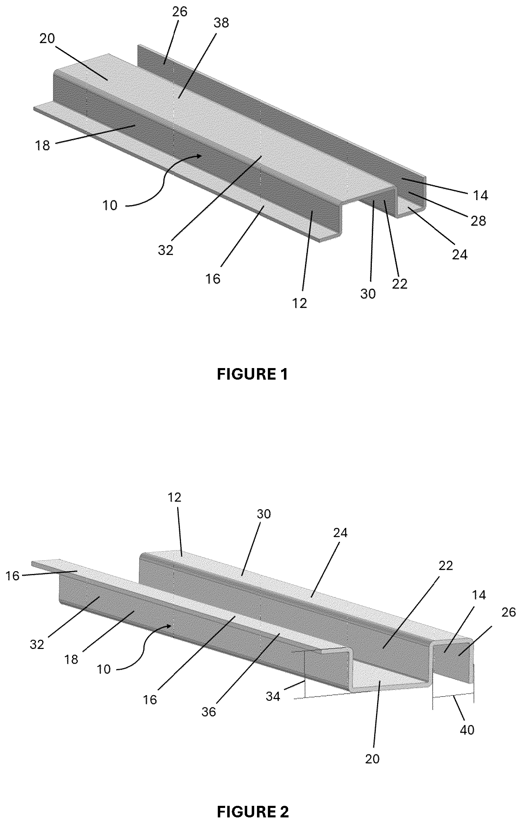

Referring first to Figures 1-3, a framework member, in this case a framework extrusion is shown at 10. Where below the framework member is indicated to be an extrusion, it is to be understood that it might equally be formed by other means e.g. stamping (for instance from sheet metal) or moulding (for instance of plastic). The extrusion 10 is formed as a single intrinsic component. In this embodiment, the extrusion 10 is made from aluminium, in this case Aluminium 6063-T6 and has a thickness of 4mm. However as will be appreciated, alternative materials and/or thicknesses can be used. The extrusion 1 has a cross-sectional form having a top-hat portion 12 and a return portion 14, the return portion 14 extending from one side of the top-hat portion 12. The top-hat portion 12 has, in order, an open brim wall 16, an open side wall 18, a crown wall 20, a closed side wall 22 and a closed brim wall 24. The open brim wall 16 and open side wall 18 are connected along respective longitudinal edges thereof. Similarly, the open side wall 18 and crown wall 20 are connected along respective longitudinal edges thereof. Similarly, the crown wall 20 and closed side wall 22 are connected along respective longitudinal edges thereof. Similarly, the closed side wall 22 and closed brim wall 24 are connected along respective longitudinal edges thereof. Together the open brim 16, open side 18, crown 20, closed side 22 and closed brim 24 wall form a top-hat shape in cross-section.

The return portion 14 has a return wall 26. The closed brim wall 24 and return wall 26 are connected along respective longitudinal edges thereof. In combination with the closed brim 24 and closed side 22 walls, the return wall 26 forms in cross-section a channel 28. In this case the channel 28 is U-shaped, but in other embodiments the channel may have a different cross-sectional shape. For instance, the return wall 26 could be angled obliquely.

More generally, the walls 16, 18, 20, 22, 24 and 26 are either parallel or perpendicular with respect to each other and could be considered to substantially follow a square wave shape in cross-section. The open brim 16, closed brim 24 and crown 20 walls are parallel with each other. The open side 18, closed side 22 and return 26 walls are parallel with each other. The open brim 16, closed brim 24 and crown 20 walls are perpendicular to the open side 18, closed side 22 and return 26 walls. In addition, the open side 18, closed side 22 and return 26 walls are of the same height, and the open brim 16 and closed brim 24 walls are coplanar. Despite this, in other embodiments, variation on this are possible (e.g. one or more of the walls 16, 18, 20, 22, 24 and 26 may be at least somewhat obliquely angled and/or there may be variation from the length relationships discussed).

In this embodiment, the extrusion 10 is longer than it is wide, though as will be appreciated, the extrusion 10 can be formed or cut to different lengths in accordance with need.

The extrusion 10 has an inner side surface 30, which is continuous across all of the extrusion 10 walls 16, 18, 20, 22, 24 and 26 and encompasses the underside of the top-hat portion 12 and an outward facing side of the return wall 26. The extrusion 10 also has an outer side surface 32, which is continuous across all of the extrusion 10 walls 16, 18, 20, 22, 24 and 26 and encompasses the top side of the top-hat portion 12 and an inward facing side of the return wall 26. Given the respective orientations of the closed brim 24 and return 26 walls, the parts of the outer side surface 32 formed by the closed brim 24 and return 26 walls, make substantially a right angle with each other.

A perpendicular distance 34 between an open brim wall inner side surface 36 of the open brim wall 16 and a crown wall outer side surface 38 of the crown wall 20 is substantially equal to a perpendicular distance 40 between a closed side wall outer side surface 42 of the closed side wall 22 and a return wall inner side surface 44 of the return wall 26. Having said this, the perpendicular distance 34 (in this case 40mm) between the open brim wall inner side surface 36 and the crown wall outer side surface 38 is somewhat smaller than the perpendicular distance 40 (in this case 40.5mm) between the closed side wall outer side surface 42 and the return wall inner side surface 44.

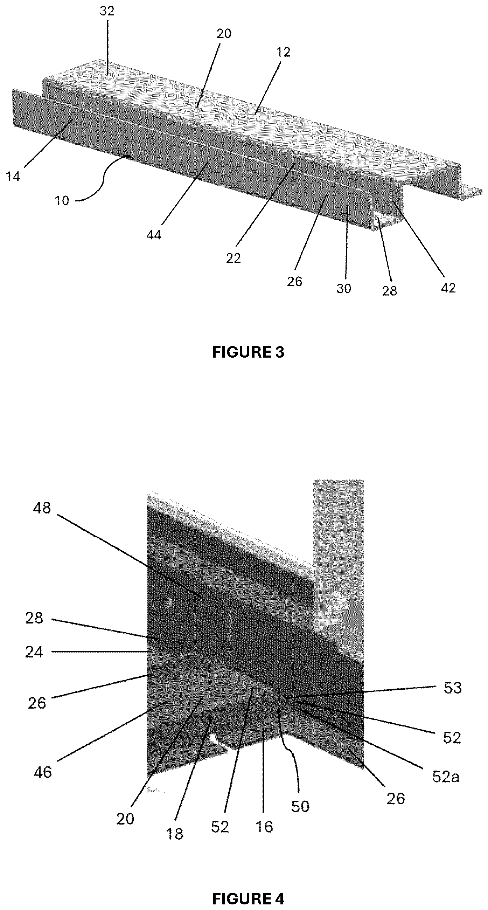

Referring now to Figures 4-7, description of various possible end and side features that may be formed or cut into the extrusion 10 is provided. Further, the manner in which such end and/or side features allow, in combination with the basic properties of the extrusion 10, supporting and/or engaging and/or attaching of multiple instances of the extrusion (e.g. with respect to each other), is also discussed. As will be appreciated, these end and/or side features may be used, and optionally combined, in various different ways in each instance of the extrusion.

Referring first to Figure 4, a first framework extrusion 46 and a second framework extrusion 48 are shown. Both the first 46 and second 48 extrusions conform in form (i.e. nominal cross-section) with the description above of the extrusion 10 and so like features are provided with like reference numerals.

The first extrusion 46 is provided with a full-step end feature generally shown at 50 at one 52 of its ends. The full-step end feature 50 has stepped back open brim 16 and closed brim walls at the end 52 relative to its open side 18, crown 20, closed side 22 and return walls (which all therefore finish at a consistent distance beyond the open brim 16 and closed brim walls). That is, the open brim 16 and closed brim walls are absent (or have absent portions) at the end 52. The stepping back of the open brim 16 and closed brim walls is achieved by removal of part of each for a length along the first extrusion 46, from an end edge 52a of the end 52, substantially corresponding to the height of the return wall 26 of the second extrusion 48. The remaining open side 18, crown 20, closed side 22 and return 26 walls of the full-step end feature 50 form a nose portion 53, which may be considered to protrude in the longitudinal direction of the first extrusion 46. With the first 46 and second 48 extrusions correctly aligned, the full-step end feature 50 allows the nose portion 53, to be inserted into the channel 28 of the second extrusion 48, anywhere along the longitudinal length of the second extrusion 48. Specifically, the stepped back open brim 16 and closed brim walls at the full-step end feature 50 remove the obstacle to insertion of the nose portion 53 that would otherwise be presented by the open brim 16 and closed brim walls of the first extrusion 46 and the return wall 26 of the second extrusion 48. In such an insertion, a height direction/axis of the first extrusion 46 is aligned with a width direction/axis of the second extrusion 48. Further, an end of the nose portion 53 of the first extrusion 46 faces the closed brim wall 24 of the second extrusion 48. Additionally, the crown wall 20 of the first extrusion 46 faces the closed side wall of the second extrusion 48. Additionally, the width direction/axis of the first extrusion 46 extends along the longitudinal direction/axis of the second extrusion 48. The first extrusion 46 can, in this embodiment, be considered an extrusion to be inserted or an inserted extrusion, whilst the second extrusion 48 can be considered a receiving extrusion.

Due to the similarity of the perpendicular distance 34 and perpendicular distance 40, the first 46 and second 48 extrusions may, to some extent, self-support and engage upon insertion of the nose portion 53, even prior to a subsequent connecting operation (in this case welding). This can assist with an assembly process, because the first 46 and second 48 extrusions may at least to some extent self-jig once the insertion has occurred. Aside from a movement to reverse the insertion or to slide the nose portion 53 along the channel 28 of the second extrusion 48, the nose portion 53 is relatively constrained. It is for instance substantially prevented from moving relative to the second extrusion 48 in a direction directly towards or away from the closed side wall of the second extrusion 48. Relative twisting may also be substantially prevented (e.g. about a longitudinal axis and/or a lateral axis of the first extrusion 46. The potential for additional contact area between the first 46 and second 48 extrusions may also naturally tend to enhance the rigidity and/or strength of the joint even following the connecting operation. The possibility for sliding of the nose portion 53 along the channel 28 of the second extrusion 48 may be advantageous, in order to allow a degree of flexibility to assist in assembly and/or a degree of adjustment.

As will be appreciated, the insertion can create a right angled T-junction or right-angled corner in a framework comprising the first 46 and second 48 extrusions.

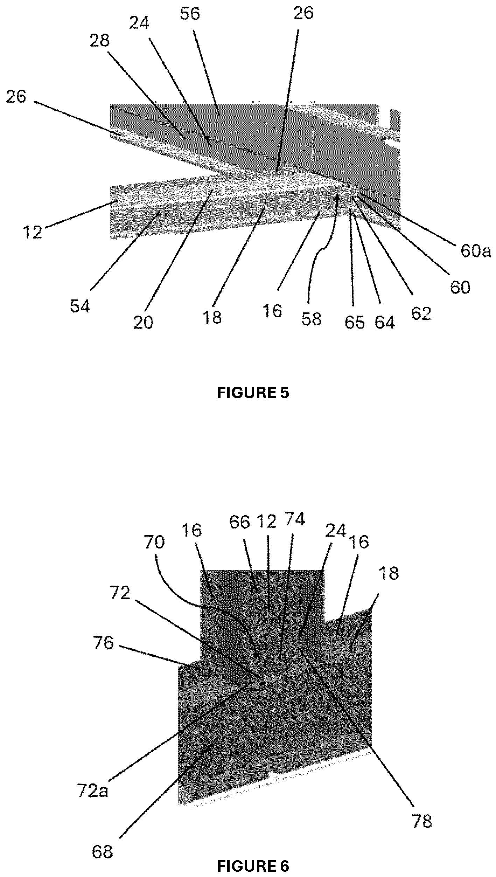

Referring now to Figure 5, a variation on the Figure 4 embodiment is described. A first framework extrusion 54 and a second framework extrusion 56 are shown. Both the first 54 and second 56 extrusions conform in form with the extrusion 10 and so like features are provided with like reference numerals. Indeed, the first extrusion 54 conforms in every way with the first extrusion 46 of the Figure 4 embodiment and the second extrusion 56 conforms in every way with the second extrusion 56 with only the following exceptions.

First, rather than a full-step end feature, the first extrusion 54 is provided with a part-step end feature generally shown at 58 at one 60 of its ends. The part-step end feature 58 is the same as the full-step end feature 50 except that the open brim 16 and closed brim walls of the first extrusion 54 have step backs at the end 60 relative to the open side 18, crown 20, closed side and return 26 walls by a length from an end edge 60a of the end 60 along the first extrusion 54 substantially corresponding to only half (rather than the whole) of the height of the return wall 26 of the second extrusion 56. That is, the open brim 16 and closed brim walls are absent, (or have absent portions) over the length indicated, at the end 52. As before, the remaining open side 18, crown 20, closed side and return 26 walls of the part-step end feature 58 form a nose portion 62, which may be considered to protrude in the longitudinal direction of the first extrusion 54.

Second, the second extrusion 56 is provided with a part-step closed side feature 64 in which the return wall 26 of the second extrusion 56 has a slot 65 (provided by part removal of the return wall 26) to reduce its height by half over a length along the second extrusion 56 substantially corresponding to the width of the top-hat portion 12 of the first extrusion 54. This is arranged to just accommodate the width/lateral extent of the open brim 16 and closed brim walls of the part-step end feature 58 of the first extrusion 54. In this embodiment, the reduction in the height of the return wall 26 is continuous, but in other embodiments, two discrete such reduction areas may be provided which are sized to accommodate respectively the open brim 16 and closed brim walls of the part-step end feature 58 of the first extrusion 54.

With the first 54 and second 56 extrusions correctly aligned, the combination of the part-step end feature 58 and the part-step closed side feature 64 allows the nose portion 62, to be inserted into the channel 28 of the second extrusion 56, at the location along the longitudinal length of the second extrusion 56 at which the part-step closed side feature 64 is located. Specifically, the (limited) step backs of the open brim 16 and closed brim walls at the part-step end feature 58, in combination with the part removal of the return wall 26 of the second extrusion 56 at the part-step closed side feature 64, removes the obstacle to insertion of the nose portion 62 that would otherwise be presented by the open brim 16 and closed brim walls of the first extrusion 54 and the return wall 26 of the second extrusion 56. In such an insertion, a height direction/axis of the first extrusion 54 is aligned with a width direction/axis of the second extrusion 56. Further, the end of the nose portion 62 (i.e. the end edge 60a) of the first extrusion 54 faces the closed brim wall 24 of the second extrusion 56. Additionally, the crown wall 20 of the first extrusion 54 faces the closed side wall of the second extrusion 56. Additionally, the width direction/axis of the first extrusion 54 extends along the longitudinal direction/axis of the second extrusion 56. The first extrusion 54 can, in this embodiment, be considered an extrusion to be inserted or an inserted extrusion, whilst the second extrusion 56 can be considered a receiving extrusion.

The combined use of the part-step end features 58 and the part-step closed side feature 64 in this way may be performed in a similar manner and have similar characteristics to use of the full-step end feature 50. In addition however, the first 54 and second 56 extrusions may engage to a greater extent even before a subsequent connecting operation (e.g. welding) and thereby self-jig to a greater extent. Specifically, in addition to the relative movement constraints imposed by the full-step end feature 50, the Figure 5 embodiment may further substantially prevent sliding of the nose portion 62 along the channel 28 of the second extrusion 56. This is due to side edges of the part-step closed side feature 64 respectively being aligned with and facing parts of side edges of the open brim wall 16 and closed brim wall of the first extrusion 54. This may be desirable where for instance enhanced self-jigging and/or strength at the joint is desired.

As will be appreciated, the insertion can create a right angled T-junction or right-angled corner in a framework comprising the first 54 and second 56 extrusions. As will be appreciated, the T-junction or corner can be created anywhere along the second 56 extrusion at which the part-step closed side feature 64 is provided (and it may be that multiple such part-step side features 64 are so provided, offering choice as to the location of the T-junction or corner and/or allowing for multiple such T-junctions and/or corners.

Relative to the embodiment of Figure 4, the embodiment of Figure 5 can further reduce the potential for mis-assembly and further increase self-jigging and/or strength, but may be considered somewhat less flexible given that the location/locations of the joint(s) is determined by the location/locations at which the part-step closed side feature(s) 64 is provided.

As will be appreciated, in other embodiments, the open brim 16 and closed brim walls of the part-step end feature 58 of the first extrusion 54 have step backs from the end edge 60a relative to the open side 18, crown 20, closed side and return 26 walls by a length along the first extrusion 54 that is a different proportion of the height of the return wall 26 of the second extrusion 56. Generally in such cases, whatever the proportion used, this would be matched by a complimentary extent of reduction in the height of the return wall 26 of the second extrusion 56 at the part-step closed side feature 64. This reduction in the height of the return wall 26 might for instance be just sufficient to allow full insertion of the nose portion 62 into the channel 28 of the second extrusion 56 (e.g. so that an end of the nose portion 62 substantially contacts the closed brim wall 24 of the second extrusion 56).

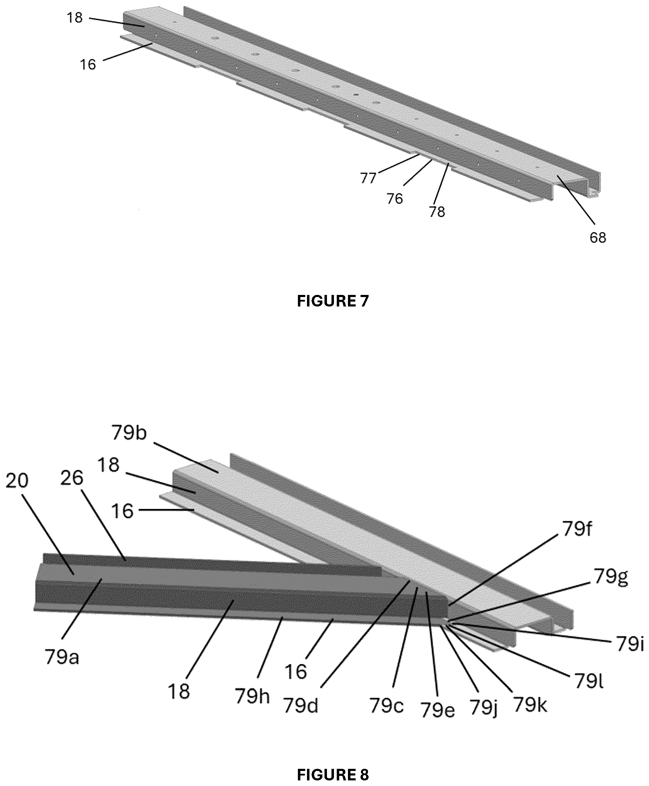

Referring now to Figures 6 and 7, an embodiment similar in character to the Figure 5 embodiment is described but relating to a joint that may be made by one extrusion corresponding in form to the extrusion 10 to open brim 16 and open side 18 walls of a further extrusion having the form of the extrusion 10. A first framework extrusion 66 and a second framework extrusion 68 are shown. Both the first 66 and second 68 extrusions conform in form with the extrusion 10 and so like features are provided with like reference numerals. Indeed, the first extrusion 66 conforms in every way with the first extrusion 54 of the Figure 5 embodiment, having a part-step end feature, generally shown at 70, at one 72 of its ends also having an end edge 72a and the part-step end feature 70 having a nose portion 74.

The second extrusion 68 is provided with a part-step open side feature 76 in which the open brim wall 16 of the second extrusion 68 has a slot 77 (provided by part removal of the open brim wall 16) to reduce its width by half over a length along the second extrusion 68 substantially corresponding to the width of the top-hat portion 12 of the first extrusion 66. This is arranged to just accommodate the width/lateral extent of the open brim 16 and closed brim 24 walls of the part-step end feature 70 of the first extrusion 66. In this embodiment, the reduction in the width of the open brim wall 16 of the second extrusion 68 is continuous (as best seen in three such continuous examples in Figure 7), but in other embodiments, two discrete such reductions may be provided, each sized to respectively accommodate one of the open brim 16 and closed brim 24 walls of the part-step end feature 70 of the first extrusion 66.

With the first 66 and second 68 extrusions correctly aligned, the combination of the part-step end feature 70 and the part-step open side feature 76 allows the nose portion 74 to be inserted so that the end edge 72a approaches and substantially abuts the open side wall of the second extrusion 68, at the location along the longitudinal length of the second extrusion 68 at which the part-step open side feature 76 is located. Specifically, the (limited) step backs of the open brim 16 and closed brim 24 walls at the part-step end feature 70 in combination with the part removal of the open brim wall 16 of the second extrusion 68 at the part-step open side feature 76, removes the obstacle to insertion of the nose portion 74 that would otherwise be presented by the open brim wall 16 and closed brim 24 wall of the first extrusion 66 and the open brim wall 16 of the second extrusion 68.

In such an insertion, the end edge 72a of the first extrusion 66 faces the open side wall 18 of the second extrusion 68. Additionally, the width direction/axis of the first extrusion 66 extends along the longitudinal direction/axis of the second extrusion 68. The first extrusion 66 can, in this embodiment, be considered an extrusion to be inserted or an inserted extrusion, whilst the second extrusion 68 can be considered a receiving extrusion.

With the combined use of the part-step end feature 70 and the part-step open side feature 76 in this way, the first 66 and second 68 extrusions may, to some extent, self-support and engage upon insertion of the nose portion 74, even prior to a subsequent connecting operation (in this case welding). This can assist with an assembly process, because the first 66 and second 68 extrusions may at least to some extent self-jig once the insertion has occurred. The nose portion 74 is substantially prevented from moving relative to the second extrusion 68 in a direction so as to directly move the crown wall 20 of the first extrusion 66 towards the open brim 16 of the second extrusion 68. This is achieved by a nose portion of the return wall 26 of the nose portion 74 abutting a remaining portion 78 of the open brim wall 16 of the second extrusion 68. Additionally, the nose portion 74 is substantially prevented from moving relative to the second extrusion 68 in a direction directly towards the open side wall 18 of the second extrusion 68 by the open side wall 18 itself. In addition, sliding of the nose portion 74 along the second extrusion 68 may be substantially prevented. This is due to side edges of the part-step open side feature 76 respectively being aligned with and facing parts of side edges of the open brim wall 16 and closed brim wall 24 of the first extrusion 66.

As will be appreciated, the insertion can create a right angled T-junction or right-angled corner in a framework comprising the first 66 and second 68 extrusions. As will be appreciated, the T-junction or corner can be created anywhere along the second 68 extrusion at which the part-step open side feature 76 is provided (and it may be that multiple such part-step side features 76 are so provided, offering choice as to the location of the T-junction or corner and/or allowing for multiple such T-junctions and/or corners.

The Figures 6 and 7 embodiment provides another support and/or engagement and/or attachment option utilising two instances of an extrusion having the form of extrusion 10. In particular it allow a right angled T-junction or right angled corner to be created abutting and extending perpendicularly from the open side wall 18 of the second extrusion 68. Further, when used in combination with the embodiment of Figure 4 and/or the embodiment of Figure 5 (e.g. where the channel 28 of the second extrusion 68 is also used as the basis for a right angled T-junction of right angled corner in the manner described with respect to Figure 4 or 5) then a 3D right angled corner or right angled T-junction may be created in a framework.

As will be appreciated the full-step end feature 50 of the first extrusion 46 may also be used to make a joint with the open brim wall 16 and open side wall 18 of an extrusion having the form of extrusion 10. This may be advantageous where for instance prior to any connecting operation (in this case welding), it is desired (e.g. for assembly purposes) to preserve the potential for relative sliding of the first extrusion 46 along the relevant instance of the extrusion 10.

Referring now to Figure 8, an embodiment similar in character to that of Figures 6 and 7 (i.e. based on a part-step end feature and part-step open side feature) is described, but which facilitates the creation of an oblique angled joint rather than a right-angled T-junction or right-angled corner joint. A first framework extrusion 79a and a second framework extrusion 79b are shown. Both the first 79a and second 79b extrusions conform in form with the extrusion 10 and so like features are provided with like reference numerals.

A part-step end feature 79c is formed at an end 79d of the first extrusion 79a with a nose portion 79e, formed by the open side 18, crown 20, closed side and return 26 walls of the first extrusion 79a at its end 79d. In order to facilitate the creation of the oblique angled joint, the nose portion 79e has an obliquely cut end edge 79f, thereby allowing it to make an oblique angle with the second extrusion 79b when abutting its open side wall 18. Furthermore, part-step backs 79g in the open brim 79h and closed brim walls at the end 79d of the first extrusion 79a are, in contrast to the rectangular step-backs used in the previously discussed embodiments, parallelograms in shape. Consequently, remaining end edges 79i of the open brim 79h and closed brim walls, are oblique and parallel with the end edge 79f of the nose portion 79e.

To complement the part-step end feature 79c, the second extrusion 79b has a part-step open side feature 79j. The part-step open side feature 79j has a slot 79k (provided by part removal of the open brim wall 16 of the second extrusion 79b) to reduce its width for a length along the second extrusion 79b substantially corresponding to the width of the top-hat portion 12 of the first extrusion 79a. This is arranged to just accommodate the width/lateral extent of the open brim 16 and closed brim walls (obliquely arranged as intended for the angle of the oblique joint) of the part-step end feature 79c of the first extrusion 79a. This includes the provision of oblique side walls 79l to the slot 79k.

As will be appreciated, this approach to the provision of an oblique angled joint can be applied mutatis mutandis to the alternative joint approaches discussed previously e.g. based on a full-step end feature or a part-step closed side feature.

As will be appreciated, the angle of the oblique angled joint can be adjusted according to need, with complimentary angular adjustments to the various oblique elements described.

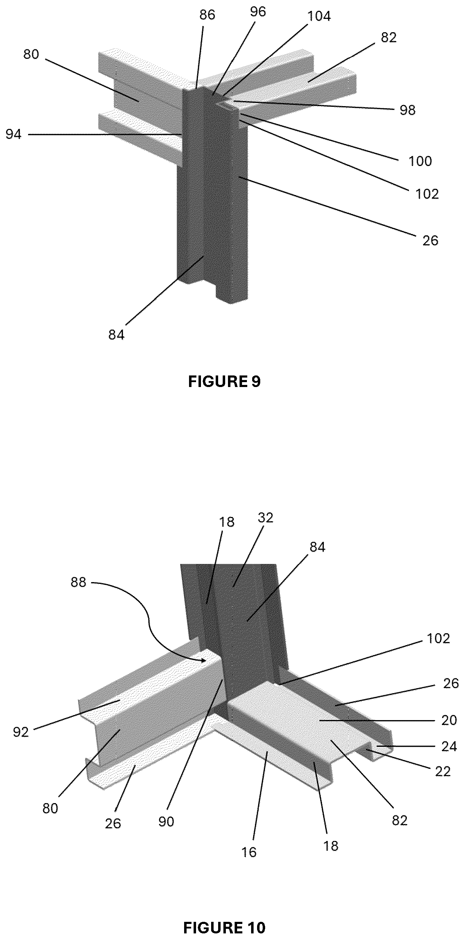

Referring now to Figures 9-11, a specific example of one way in which three instances of extrusion having the same form as extrusion 10 may lend themselves to creating a 3D right angled corner to a framework is described. In these Figures, a first extrusion is shown at 80, a second extrusion is shown at 82 and a third extrusion is shown at 84. Each of the first 80, second 82 and third 84 extrusions conform in form with the extrusion 10 and so like features are provided with like reference numerals.

In the embodiments of Figures 9-11, the first 80, second 82 and third 84 extrusions have their longitudinal axes aligned respectively with an x a y and z axis and they meet to form a 3D right angled corner 86 using, in part, end features already described as well as some further end features and/or machined modifications.

The first extrusion 80 has a part-step end feature 88 at one 90 of its ends used in forming the 3D right angled corner 86 of a framework 92. The third extrusion 84 has a part-step open side feature 94 at one 96 of its ends used in forming the 3D right angled corner 86. The part-step end feature 88 and part-step open side feature 94 are the same, respectively, as the part-step end feature 70 and part-step open side feature 76 described with reference to the embodiment of Figures 6 and 7. Further, the first extrusion 80 and third extrusion 84 are oriented with respect to one another in the same way as the first 66 and second 68 extrusions described with reference to the embodiment of Figures 6 and 7. Consequently, the first 80 and third 84 extrusions form a 2D right angled corner in the same manner as contemplated in the description of the embodiment of Figures 6 and 7.

The second extrusion 82 has an end feature not previously described, a centre-stepped end feature 98, at one 100 of its ends used in forming the 3D right angled corner 86. In the centre-stepped end feature 98, the open side 18, crown 20 and closed side 22 walls of the second extrusion 82 are stepped back (e.g. removed) at the end 100 relative to the closed brim 24 and return 26 walls of the second extrusion 82 by a length along the second extrusion 82, from an end edge 102 of the end 100, substantially corresponding to half of the height of the open side wall 18 of the third extrusion 84. To complement this, the end 96 of the third extrusion 84 has its return wall 26 stepped back (e.g. removed) by substantially half its height for a length along the third extrusion 84, from an end edge 104 of its end 96, substantially corresponding to the height of the return wall 26 of the second extrusion 82. This complementary relationship allows the second extrusion 82 to engage the third extrusion 84 with the end edge 102 of the end 100 facing the outer side surface 32 of the third extrusion 84. Further, with the outer side surface 32 of the second extrusion 82 facing directly the longitudinal direction/axis of the third extrusion 84 and away from the end 96 of the third extrusion 84. Further, with the width/lateral directions of the second 82 and third 84 extrusions extending in the same direction.

Further features allow accommodation and cooperation of the return wall 26 of the first extrusion 80 and the open brim wall 16 of the second extrusion 82. The first extrusion 80 has a rectangular notch 106 cut to reduce to part of its height its return wall 26 between a first length and a second from an end edge 108 of the end 90 of the first extrusion 80. The first length is substantially half the height of the open brim wall 16 of the second extrusion 82 and the second length is substantially the full height of the open brim wall 16 of the second extrusion 82. To complement the rectangular notch 106, the open brim wall 16 of the second extrusion 82 is provided with a protruding tooth 110 arranged to engage the rectangular notch 106. The open brim wall 16 of the second extrusion 82 is removed by a length from the end edge 102 of substantially the height of the return wall 26 of the first extrusion 80 for substantially a first half (nearest to its interface with the open side wall 18 of the second extrusion 82) of the width of the open brim wall 16 of the second extrusion 82. For substantially a second half (furthest from its interface with the open side wall 18 of the second extrusion 82) of the width of the open brim wall 82, the open brim 16 of the second extrusion 82 is again removed, but only by a length from the end edge 102 substantially corresponding to the height of the return wall 26 of the first extrusion 80 minus the height reduction in the return wall 26 of the first extrusion 80 produced by the rectangular notch 106. The removals from the open brim wall 16 of the second extrusion 82 give rise to the protruding tooth 110, which substantially fully occupies the rectangular notch 106 when the 3D right angled corner 86 is formed.

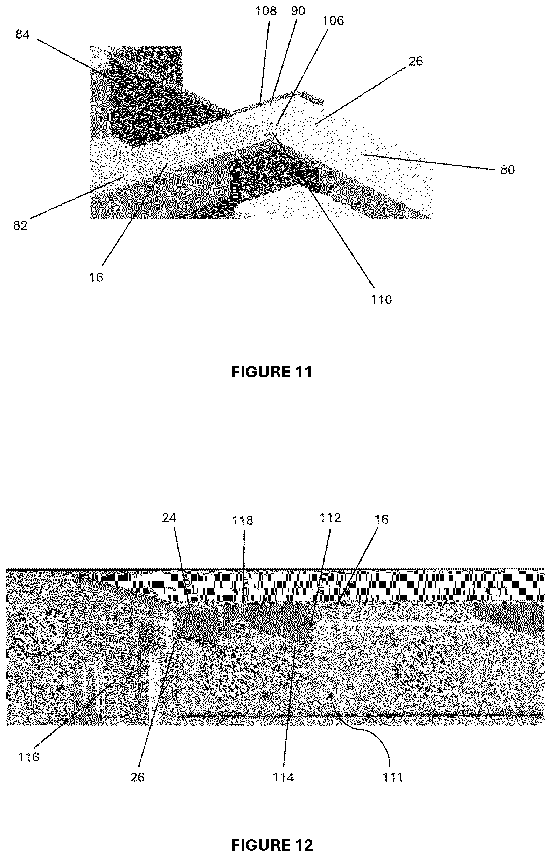

Referring now to Figure 12, a structure 111 formed in part by a framework 112 comprising an extrusion 114 is shown. The extrusion 114 conforms in form with the extrusion 10 and so like features are provided with like reference numerals. As can be seen, in this embodiment, the return wall 26 of the extrusion 114 is used to support and secure a first panel 116 externally covering, in part, the framework 112. Meanwhile the closed brim 24 and open brim 16 walls are used to support and secure a second panel 118, where the second panel 118 extends perpendicularly to the first panel 116. As will be appreciated, one or more additional extrusions corresponding to one or more of those previously discussed could be connected to the extrusion 114 in one or more of the manners previously discussed, in order to further support and/or attach the first 116 and/or second 118 panels and/or further framework elements and/or panels.

As will be appreciated, not least from consideration of the embodiments of Figures 9-11 and/or 12, it is possible to create an entire framework e.g. of a box nature, using only extrusions of the form of extrusion 10.

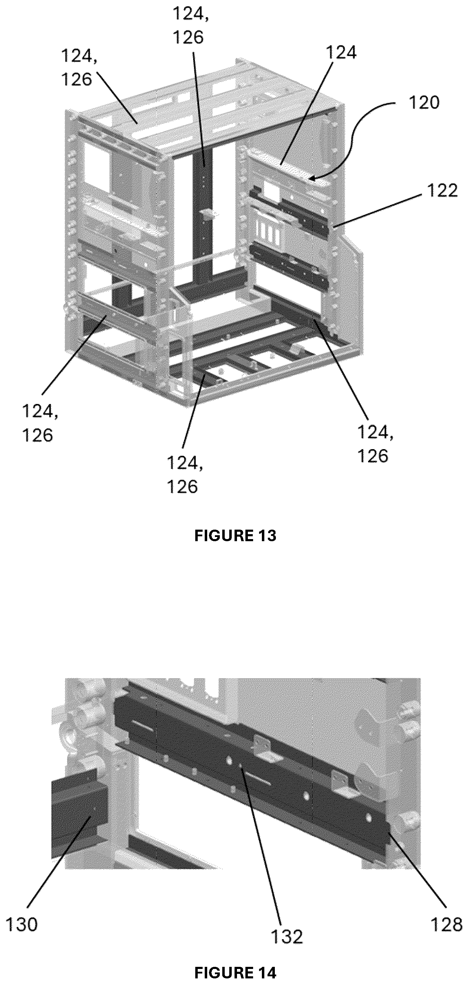

Referring now to Figure 13, a box structure is generally shown at 120. In this case the box structure 120 is a power distribution and conversion enclosure, but as will be appreciated, in other embodiments the box structure may have another purpose. The box structure 120 has a box framework 122 which provides its structural support. The box framework 122 comprises framework elements 124 (only some labelled), several of which are framework extrusions 126 (only some labelled) having the same form as the extrusion 10. Additional instances of the framework elements 124 are of alternative form. Several of the extrusions 126 utilise end and side features corresponding to those discussed above in forming right angled corner and right angled T-junction connections among themselves. Additionally, alternative end features to those discussed above form part of some of the extrusions 126, (e.g. a tenon end feature 128 best seen in Figure 14) particularly those used in forming a connection between one of the extrusions 126 and a framework element 124 that is not an instance of the extrusions 126. Further, one or more of the extrusions 126 used have no particular end feature at one or both ends (i.e. the cross-section of the extrusion remains consistent to and includes the relevant end). This can for instance be seen in an extrusion 130, best seen in Figure 14.

In making measurement in order to perform cuts and/or other machining actions to extrusions having the form of extrusion 10 (e.g. in order to determine the length of the relevant extrusion and/or to form any of the end and/or side features) a master datum is, in some embodiments, provided as a reference. The master datum may, as in this case, be a circular hole 132 (e.g. drilled) through the crown wall 20. The circular hole 132 may be located centrally across the width of the crown wall 20 and/or at an intended mid-point of the length of the extrusion. Any subsequent operation to the extrusion e.g. a cutting operation at an end thereof, may then be referenced to this circular hole 132. This may reduce the prospects for cutting errors, e.g. allowing cutting tolerances to be aggregated along the relevant extrusion in preference to using one end of the extrusion as a reference point. The circular hole 132 may additionally or alternatively serve as a positional reference point for locating the extrusion during assembly e.g. on a weld table.

It will be appreciated that various changes and modifications can be made to the present invention without departing from the scope of the present application.

## Claims

1. A framework member comprising, a top-hat portion and a return portion, where
the top-hat portion comprises an open brim wall, an open side wall extending from the open brim wall, a crown wall extending from the open side wall, a closed side wall extending from the crown wall and a closed brim wall extending from the closed side wall, and
the return portion comprises a return wall extending from the closed brim wall, and where
the open brim, open side, crown, closed side and closed brim walls form, in cross-section, a top-hat shape and
the closed side, closed brim and return wall form, in cross-section, a channel.

2. The framework member according to claim 1 where the open brim, crown and closed brim walls are substantially parallel with each other and are substantially perpendicular to the open side, closed side and return walls.

3. The framework member according to any preceding claim where the open side and closed side walls are of substantially the same height.

4. The framework member according to claim 3 where the return wall is of substantially the same height as the open side and closed side walls.

5. The framework member according to any preceding claim where the member has an inner side surface corresponding to an inner side of the top-hat shape and an outer side surface corresponding to an outer side of the top-hat shape and a perpendicular distance between an open brim wall inner side surface of the open brim wall and a crown wall outer side surface of the crown wall is substantially equal to a perpendicular distance between a closed side wall outer side surface of the closed side wall and a return wall inner side surface of the return wall.

6. The framework member according to claim 5 where the member has a full-step end feature at one of its ends where the open brim and closed brim walls are absent from the end of the member, leaving a nose portion of the full-step end feature formed by the open side, crown, closed side and return walls.

7. The framework member according to claim 5 or claim 6 where the member has a part-step end feature where the open brim and closed brim walls are absent from the end of the member for a length along the member that is less than the height of the return wall and a nose portion is formed by the open side, crown, closed side and return walls.

8. The framework member according to any preceding claim where the member has a part-step closed side feature where the return wall is provided with a slot to reduce its height over a length along the member substantially corresponding to the width of the top-hat portion.

9. The framework member according to any preceding claim where the member has a part-step open side feature where the open brim wall is provided with a slot to reduce its width over a length along the member substantially corresponding to the width of the top-hat portion.

10. A framework comprising the framework member according to any of claims 1 to 9.

11. The framework of claim 10 where the framework member is a first framework member according to claim 6 and the framework further comprises a second framework member according to any of claims 1 to 9 and where a substantially right angled T-junction or right angled corner or oblique angle is formed by the engagement of the first and second framework members, such that the nose portion of the full-step end feature of the first framework member is inserted between the closed side and return walls of the second member.

12. The framework of claim 10 where the framework member is a first framework member according to claim 7 and the framework further comprises a second framework member according to claim 8 and where a substantially right angled T-junction or right angled corner or oblique angle is formed by the engagement of the first and second framework members, such that the nose portion of the part-step end feature of the first framework member is inserted between the closed side and return walls of the second member and with respective parts of the open brim and closed brim walls of the first framework member being accommodated within the part-step closed side feature of the second framework member.

13. The framework of claim 10 where the framework member is a first framework member according to claim 7 and the framework further comprises a second framework member according to claim 9 and where a substantially right angled T-junction or right angled corner or oblique angle is formed by the engagement of the first and second framework members, such that the end of the first framework member having the part-step end feature is facing an open side wall outer side surface of the open side wall of the second framework member and with respective parts of the open brim and closed brim walls of the first framework member being accommodated within the part-step open side feature of the second framework member.

14. The framework according to any of claims 10 to 13 that is a box framework.

15. The framework according to any of claims 10 to 14 made entirely from multiple instances of the framework member of any of claims 1 to 9.
